# FASCICULE DE BREVET EUROPEEN

(11) **EP 3 408 091 B1**
(45) Date de publication et mention de la délivrance du brevet: **15.04.2020**
(21) Numéro de dépôt: 16831827.7
(22) Date de dépôt: 22.12.2016
(51) Int. Cl.: B32B 17/10, B60R 16/023, H01R 9/24

(54) **VITRAGE FEUILLETE DE VEHICULE AVEC ECRAN AMOLED**
FAHRZEUG-VERBUNDVERGLASUNG MIT AMOLED-BILDSCHIRM
LAMINATED VEHICLE GLAZING WITH AMOLED SCREEN

(30) Priorité: 31.12.2015 FR 1563487
(43) Date de publication de la demande: 05.12.2018
(73) Titulaire: Saint-Gobain Glass France, 92400 Courbevoie (FR)
(72) Inventeur: LABROT, Michael, 52072 Aachen (DE); OFFERMANN, Volkmar, 52249 Eschweiler (DE); REUL, Bernhard, 52134 Herzogenrath (DE)
(74) Mandataire: Saint-Gobain Recherche
(86) Numéro de dépôt international: PCT/FR2016/053643
(87) Numéro de publication internationale: WO 2017/115043

(56) Documents cités:
- WO-A1-2015/041106
- DE-A1-102008 004 049
- FR-A1- 2 933 505
- FR-A1- 3 002 677
- US-A1- 2010 179 725
- US-A1- 2014 230 899

## Description

L'invention concerne un vitrage feuilleté de véhicule et plus particulièrement un vitrage feuilleté de véhicule intégrant un écran AMOLED.
Il existe de plus en plus de pare-brises intelligents délivrant des informations au conducteur.
Le document WO2015041106 propose en particulier un pare-brise automobile comportant un écran AMOLED (Active Matrix Organic Light Emitting Diode en anglais) -entre les faces internes des deux vitrages, écran agencé en périphérie et masqué dans la bordure émaillée en face F2 c'est-à-dire la face interne du vitrage le plus extérieur. L'écran AMOLED en position horizontale vise à remplacer le rétroviseur interne pour voir l'arrière du véhicule -classiquement sous forme d'un miroir- et est situé préférentiellement dans la partie centrale le long du bord longitudinal haut du pare-brise. Il est couplé avec une caméra à l'arrière du véhicule.

L'invention a pour but de perfectionner ce vitrage feuilleté de véhicule à écran AMOLED notamment pare-brise à écran AMOLED.

A cet effet, la présente invention a pour objet un vitrage feuilleté de véhicule notamment pare-brise ou vitrage latéral de véhicule notamment routier, comportant :
- un premier vitrage, de préférence bombé, de préférence en verre minéral, de préférence teinté, notamment gris ou vert, avec une première face principale dite F1 destinée à être coté extérieur du véhicule et une deuxième face principale opposée dite F2, vitrage d'épaisseur E1 de préférence (surtout dans le domaine routier, pour une automobile) d'au plus 2,5mm, même d'au plus 2mm - notamment 1,9mm, 1,8mm, 1,6mm et 1,4mm- ou même d'au plus1,3mm ou d'au plus 1 mm,
- un intercalaire de feuilletage en matière polymérique (clair, extraclair), de préférence thermoplastique, côté face F2, d'épaisseur (totale) E2 de préférence surtout dans le domaine routier, pour une automobile) d'au plus 2,2mm mieux d'au plus 2mm, d'au plus 1,5mm ou même d'au plus 0,76mm, par exemple composé de plusieurs feuillets par exemple 3 feuillets, notamment en retrait du chant du deuxième vitrage (d'au plus 5mm ou même d'au plus 2mm ou d'au plus 1mm)
- un deuxième vitrage, de préférence bombé (comme le premier vitrage), de préférence en verre minéral, avec une troisième face principale dite F3 côté intercalaire de feuilletage et une quatrième face principale opposée dite F4, notamment destinée à être côté intérieur du véhicule, éventuellement teinté (ou clair et même avec une couche électroconductrice en face F3 voire F4), d'épaisseur E'1 de préférence inférieure à E1, même d'au plus 2,2mm (surtout dans le domaine routier, pour une automobile) - notamment 1,9mm, 1,8mm, 1,6mm et 1,4mm- ou même d'au plus1,3mm ou d'au plus 1mm, l'épaisseur totale des vitrages E1+E'1 étant de préférence (surtout dans le domaine routier, pour une automobile) strictement inférieure à 4,4mm, même à 3,7mm, l'un au moins -et mieux les deux-des premier et deuxième vitrages étant en verre, l'autre éventuellement en matière organique, polymérique comme un polycarbonate,
- entre la face F2 et la face F3, un premier écran de visualisation à diode électroluminescente organique dit écran AMOLED 3 flexible, comportant un ensemble de pixels, le premier écran AMOLED comportant une zone (centrale) d'affichage d'informations en dynamique, - l'écran AMOLED comportant un premier support flexible (matière polymérique verre, voire même métal) porteur de système(s) électroluminescent(s) organique(s) entre deux électrodes- et écran AMOLED d'épaisseur E3 inférieure à E2 de préférence subcentimétrique et même d'au plus 0,5mm, écran AMOLED ayant une face principale avant orientée vers F3 et une face principale arrière orientée vers F2, - l'écran AMOLED étant couvert par une épaisseur non nulle d'intercalaire de feuilletage -et de préférence au sein de l'intercalaire de feuilletage- donc avec une épaisseur non nulle E21 d'intercalaire de feuilletage entre la face arrière et F2 et/ou avec une épaisseur non nulle E22 entre la face avant et F3, E2 correspondant à l'épaisseur à côté de l'écran AMOLED (notamment E2 >à E21+E22 et sensiblement égale à E3), l'écran AMOLED est notamment agencé en périphérie,
- un élément de connexion électrique 4 de l'écran AMOLED avec une partie dite terminale contre ou fixée (par collage comme un adhésif double face notamment sensible à la pression) en face F4 (sans s'étendre jusqu'à la zone d'affichage, et même laissant une place à un boitier d'interface), de préférence avec une partie dite de connectique entre la face F2 et la face F3, d'épaisseur E4 inférieure à E2 et de préférence subcentimétrique, avec une surface avant côté face F3 et une surface arrière côté face F2, partie de connectique couverte par une épaisseur non nulle d'intercalaire de feuilletage et même de préférence partie de connectique au sein de l'intercalaire de feuilletage (comme l'écran AMOLED) avec une épaisseur non nulle E41 d'intercalaire de feuilletage entre la surface arrière et la face F2 et avec une épaisseur non nulle E42 (de préférence identique à l'épaisseur E3) entre la surface avant et la face F3).
La partie de connectique est reliée (de préférence liaison permanente) à l'écran AMOLED et prolonge (directement) l'écran AMOLED en direction du chant du deuxième vitrage, et l'élément de connexion électrique flexible se prolongeant hors du chant du deuxième vitrage via une partie extérieure (d'épaisseur E'4 inférieure à E4 au-delà du chant du deuxième vitrage), qui est courbée (flexible) et ladite partie dite terminale.

L'élément de connexion en particulier est pour l'alimentation électrique et (de préférence)/ou transportant des signaux de données (simultanément ou séquentiellement) en particulier élément de connexion électrique comportant une ou des pistes d'alimentation électrique (« supply lines » en anglais) » et/ou une ou des pistes pour les signaux de données (« data lines » en anglais), et des composants électroniques (éventuellement en particulier dans la partie de connectique).
Le vitrage selon l'invention comprend, sur la face F4, un boitier d'interface connecté (par un système de connexion male-femelle par enfichage, par clipsage, par encliquetage ou toute liaison de préférence amovible) à la partie terminale de l'élément de connexion électrique (collé par adhésif ..), renfermant un ou des composants électroniques (sur une carte de circuit imprimé de type PCB par exemple), de préférence de commande) de l'écran AMOLED (et/ou d'échange de données avec l'écran AMOLED), le boitier d'interface étant en outre connecté (au moins) avec un système filaire (fil ou câble etc) d'alimentation électrique, notamment par un système de connexion male femelle par enfichage, par clipsage, par encliquetage ou toute liaison amovible de préférence, notamment extérieur au vitrage et s'étendant hors de la face F4 du vitrage (le long du chant).
Le vitrage selon l'invention comprend, sur la face F4, un boitier d'interface connecté à la partie terminale de l'élément de connexion électrique et renfermant un ou des composants électroniques notamment de commande de l'écran AMOLED, le boitier d'interface étant (éventuellement uniquement) en outre connecté avec un système filaire d'alimentation électrique notamment sur un même bord ou sur un bord distinct du boitier d'interface.
Le boitier d'interface permet de gérer moins de fils ou câbles de faciliter le montage démontage et l'échange de données entre écran AMOLED et un réseau local, un téléphone, un ordinateur. Il peut permettre de séparer connectique et interface électronique de commande de l'écran AMOLED.
Le système filaire d'alimentation électrique n'alimente donc pas de préférence directement sur la partie terminale.
Le boitier peut être étanche à l'humidité

Selon une réalisation, le boitier d'interface peut en outre être connecté à un système filaire (câble etc.) de transports de signaux de données (à un « busdriver « en anglais), pour l'écran AMOLED, notamment par un système de connexion male femelle, par enfichage, par clipsage, par encliquetage ou toute liaison amovible de préférence, notamment extérieur au vitrage et s'étendant hors de la face F4 du vitrage (le long du chant). Le système filaire de transports de signaux de données pour l'écran AMOLED peut être sur un même bord du boitier d'interface ou sur un bord distinct que pour le système filaire d'alimentation électrique.

Le boitier peut être parallélipédique et/ou :
- avec un bord longitudinal orienté vers le chant du deuxième vitrage connecté audit connecteur du système filaire d'alimentation électrique
- avec un bord latéral connecté audit connecteur de la partie terminale
- et même avec un autre bord latéral connecté audit connecteur du système filaire pour les données.

Le boitier peut être parallélipédique et/ou avec un bord longitudinal orienté vers le chant du deuxième vitrage connecté audit connecteur du système filaire d'alimentation électrique et connecté audit connecteur de la partie terminale voire même connecté audit connecteur du système filaire pour les données.

Le boitier peut être parallélipédique et/ou :
- avec un bord longitudinal orienté vers le chant du deuxième vitrage éventuellement connecté audit connecteur du système filaire de données
- avec un bord latéral connecté audit connecteur de la partie terminale
- avec un autre bord latéral connecté audit connecteur du système filaire d'alimentation électrique.

Selon une réalisation, le boitier d'interface comporte un fond qui porte ou est une carte de circuit imprimé.
Le boitier d'interface peut être en outre connecté à un système filaire de transports de signaux de données pour l'écran AMOLED qui s'étend hors du vitrage (de préférence en périphérie (et sous une garniture, montant en plastique etc).
Le boitier peut comprendre un récepteur de signaux d'antenne. Les signaux d'antenne (radiofréquence, fréquence micro-onde, HF, UHF) sont par exemple pour le télépéage ou issus d'un réseau local de communication comme le BLUETOOTH, le WIFI, le WLAN transportant des données pour l'écran AMOLED, notamment pour sa commande.

Le boitier peut être monté sur la partie terminale ou est adjacent à la partie terminale et connecté à une extrémité de la partie terminale et contre ou fixé (par collage comme un adhésif double face, sensible à la pression) à ladite face F4.
Le fond du boitier peut correspondre à une zone de la surface de la partie terminale.

Le boitier d'interface est en en matière plastique notamment avec des moyens de blindage électromagnétique additionnel et/ou métallique avec une fenêtre de communication pour réception de signaux

Le boitier d'interface est de préférence masqué, notamment derrière une garniture du véhicule, à une distance d du chant du deuxième vitrage d'au plus quelques cm, par exemple moins de 5cm.

L'invention s'applique aussi bien lorsque :
- l'écran AMOLED est dans le clair de vitre et la partie de connectique est en périphérie (notamment opaque ou faiblement transparent) ou absente (l'élément de connexion absent du feuilleté, pouvant être « sans fil »)
- l'écran AMOLED et la partie de connectique sont en périphérie (notamment opaques ou faiblement transparents).
L'écran AMOLED (comme l'élément de connexion éventuel) est de préférence au sein de feuilletage pour une meilleure tenue mécanique. Ainsi, l'intercalaire de feuilletage est alors présent à l'avant et à l'arrière de l'écran AMOLED (comme de l'élément de connexion éventuel) ce qui est avantageux par rapport à une solution dissymétrique dans laquelle l'écran AMOLED (comme l'élément de connexion éventuel) est rapporté (contre ou fixé par adhésif double face ou colle ou contact par adhérence) à la face F2 ou la face F3.
Pour les pare-brises en particulier de véhicule routier, les vitrages sont de préférences bombés et même suivant deux directions, et de préférence avec deux vitrages en verre minéral et même avec une intercalaire de feuilletage en PVB. Dans ce cas, l'écran AMOLED flexible s'adapte aux courbures comme l'éventuelle partie de connectique (et le premier capteur sur film flexible).
De préférence le vitrage feuilleté forme un pare-brise de véhicule routier tel qu'une automobile, un camion, avec les premier et deuxième vitrage en verre minéral bombés et même un intercalaire de feuilletage en PVB et un écran AMOLED au sein du feuilletage (tout comme la partie de connectique).

L'élément de connexion peut être « sans fil ». On préfère toutefois un connecteur (plat) flexible selon l'invention pour le transport des signaux de puissance et/ou de données à un ou des connecteurs sans fil (« wireless ») par induction ou capacitif etc. L'élément de connexion électrique de préférence d'épaisseur submicronique E4 sensiblement égale à E2 et d'épaisseur E'4 inférieure à E4 au-delà du chant du deuxième vitrage, est de préférence courbé et contre ou mieux fixé par collage en face F4 sans s'étendre jusqu'à la zone d'affichage.
L'élément de connexion est avantageusement partiellement recouvert ou enrobé, le cas échéant, de tout matériau pour en augmenter l'épaisseur à une valeur essentiellement égale à celle de l'écran AMOLED.
L'élément de connexion est de préférence un circuit imprimé flexible (« fpc » en anglais). L'élément de connexion est de préférence capable d'adresser un grand nombre de pixels.
L'élément de connexion électrique flexible (notamment la partie de connectique) peut être de largeur inférieure ou sensiblement égale à celle de l'écran AMOLED, typiquement de largeur de 50mm pour de largeurs (dimension horizontale) d'AMOLED d'au moins 100mm et même de plus de 150mm. Les grands (larges) écrans peuvent avoir plusieurs éléments de connexion électrique flexibles de préférence sur un même bord de l'écran AMOLED.

La distance entre la terminaison de l'élément de connexion électrique et le chant du deuxième vitrage est suffisamment grande pour que cette terminaison soit accessible lors du montage ou du démontage. La longueur totale (dépliée) est ajustée pour l'élément de connexion soit plié autour du deuxième vitrage et fixée en face F4. A partir de la sortie du verre intérieur on prévoit de préférence une distance de 20 à 150mm.

Dans une réalisation, l'élément de connexion électrique (notamment la partie de connectique) comporte :
- un support flexible de préférence polymérique transparent ou non (comme un PET etc) avec première face avant et première face arrière, des fils ou de préférence des pistes conductrices côté avant ou arrière,
- éventuellement des composants électroniques comme des transistors
- les fils ou pistes (et composants électroniques) étant couvertes par une matière électriquement isolante, telle une couche de résine ou vernis (dépôt liquide etc) ou un film de protection transparent ou non (PET, polyimide etc) par exemple adhésivé,

La partie de connectique peut être reliée par tout moyen connu à l'écran AMOLED : clipsage, enfichage. De préférence la partie de connectique et l'écran AMOLED sont reliés par une ou des liaisons (solides) permanentes. Une liaison entre la partie de connectique et l'écran AMOLED peut se faire sur un bord technique de l'écran AMOLED.
De préférence, comme film polymérique flexible on choisit un polyéthylène téraphtalate PET, un polyimide, un polyester, un poly(chlorure de vinyle) PVC, un polycarbonate, polyétheréthercétone (PEEK), un acrylate, ceci pour l'un au moins des éléments suivants :
- l'écran AMOLED (substrat, film de protection arrière ou avant : film de façade etc),
- l'élément de connexion électrique notamment la partie de connectique (substrat, film de protection arrière ou avant).

Dans une réalisation, le vitrage feuilleté comporte une pluralité d'écrans AMOLEDS, notamment en périphérie d'un même bord longitudinal ou latéral, chacun avec un boitier d'interface dédié ou un boitier d'interface commun.

L'écran AMOLED peut être opaque ou transparent. L'écran AMOLED transparent (dans le clair de vitre en zone périphérique ou non) est de préférence défini par une transmission lumineuse (TL) de la zone du vitrage feuilleté le comprenant au moins égale à 70%.
L'écran AMOLED moins transparent (destiné à être toujours en périphérie) est de préférence défini par une transmission lumineuse (TL) de la zone du vitrage feuilleté le comprenant inférieure à 20% ou même à 10%.
Un écran AMOLED opaque peut être défini comme ayant une TL nulle (par exemple par ajout d'une couche ou peinture -métallique...- à l'arrière du substrat porteur du système AMOLED).

Dans le cas d'un pare-brise en particulier (notamment véhicule routier), cet écran AMOLED - peut être agencé en périphérie et de préférence en zone centrale du bord longitudinal supérieur en particulier dans une zone ou la largeur de la couche de masquage externe est de largeur L1 plus grande que sa largeur L0 côté conducteur et/ou copilote.
Cela permet d'agencer un écran AMOLED (opaque ou faiblement transparent) de plus grande taille notamment avec une plus grande hauteur H3 (dimension suivant la verticale). L'écran AM OLED peut aussi être plus vers le centre (bord au plus proche de la frontière.

De préférence, la couche de masquage externe est en émail et en face F2 derrière l'écran AMOLED et le ou les éventuels autres écrans AMOLED.
A l'état off, il est possible de ne pas distinguer la zone d'écran AMOLED de la zone de masquage plus en arrière. On peut prévoir adapter la couleur de la couche de masquage externe (émail notamment, en face F2) en conséquence.

Dans une réalisation, l'écran AMOLED est transparent et dans le clair de vitre ou en ce que l'écran AMOLED (transparent ou opaque) est masqué par une couche de masquage dite externe entre la face arrière de l'écran AMOLED et la face F2 (, et/ou l'élément de connexion électrique est masqué de l'extérieur notamment par une couche de masquage dite externe entre la surface arrière et la face F2 et le ou les bords techniques de l'écran AMOLED ainsi que l'élément de connexion sont masqués de l'intérieur par une couche de masquage dite interne en face F3 ou F4.

Dans une réalisation préférée, l'écran AMOLED couvre au plus toute la zone périphérique visible par le conducteur (ou copilote si écran AMOLED de son côté) dans le pare-brise de véhicule routier (automobile) jusqu'au bord de la zone centrale de vision transparente et plus précisément :
- jusqu'au bord supérieur de la zone centrale de vision transparente si l'écran AMOLED est agencé en haut de manière horizontale côté conducteur (ou copilote si écran AMOLED de son côté) le long du bord longitudinal supérieur côté conducteur (ou passager)
- jusqu'au bord inférieur de la zone centrale de vision transparente si l'écran AMOLED est agencé en bas de manière horizontale côté conducteur (ou copilote si écran AMOLED de son côté) le long du bord longitudinal inférieur côté conducteur (ou passager)
- jusqu'au bord supérieur de la zone centrale de vision transparente si l'écran AMOLED est agencé en haut de manière horizontale ou verticale dans la zone centrale du bord longitudinal supérieur
- jusqu'au bord gauche de la zone centrale de vision transparente (respectivement droite) si l'écran AMOLED est agencé de manière verticale à gauche de préférence côté conducteur (respectivement droite de préférence côté copilote) le long du bord latéral gauche, de préférence en partie basse (moitié inférieure du bord latéral) pour être plus larges

Il en est de même pour ledit ou lesdits autres écrans AMOLED - si opaques ou faiblement transparent de préférence masqués par la couche de masquage externe, de préférence en face F2-.

Les bords (ou limites) supérieur, inférieur, latéraux (gauche et droite) de la zone de vision centrale transparente sont notamment définis par une norme de régulation. Par exemple pour un pare-brise de véhicule routier, automobile, il s'agit de la zone B réduite définie selon la norme européenne UN-ECE R43 annexe 18, en particulier page 133 et § 2.4. La limite supérieure de la zone centrale de vision transparente est de préférence définie à partir d'un angle entre l'horizontale et 7° à partir d'un point de référence (l'œil du conducteur, œil à la hauteur Z par rapport au siège du véhicule avec Z= 665mm pour un grand conducteur ou Z=589mm pour un petit conducteur.

A partir du bord concerné du vitrage feuilleté notamment pare-brise de véhicule routier, on définit les distances suivantes :
- h1 distance entre le bord supérieur et la limite supérieure de la zone périphérique de vision du conducteur (ou du copilote si écran AMOLED de son côté) dans le véhicule, de préférence d'au moins 15mm et même d'au moins 50 ou 90mm
- h'1 distance entre le bord inférieur et la limite inférieure de la zone périphérique de vision du conducteur (ou du copilote si écran AMOLED de son côté) dans le véhicule de préférence d'au moins 40mm et même d'au moins 100 ou 200mm
- h4 distance entre le bord latéral (gauche ou droit) et la limite latérale de la zone périphérique de vision du conducteur (ou du copilote si écran AMOLED de son côté) dans le véhicule de préférence d'au moins 15mm et même d'au moins 20 ou 40mm.

Hors zone de l'écran AMOLED (et/ou desdits autres écrans AMOLED) on peut former une couche de masquage périphérique externe (en face F2) comme l'émail, du chant jusqu'à h1, h'1, h4 en dépassant par exemple de la zone de vision (prédéterminée) d'au plus 2cm comme classiquement.

Selon l'invention on peut augmenter à façon la largeur de la couche de masquage externe pour masquer l'écran AMOLED (et le ou lesdits autres écrans AMOLED) et au maximum jusqu'aux limites de la zone centrale de transparence. Le masquage externe est donc possible à partir de la limite de zone de vision B réduite jusqu'au bord du (premier) vitrage.

En fonction du bord concerné du vitrage feuilleté notamment pare-brise de véhicule routier, on définit les distances suivantes :
- h2 distance entre le bord supérieur et la limite supérieure de la zone centrale de transparence côté conducteur (ou copilote si écran AMOLED de son côté), de préférence d'au moins 120mm et même de plus de 150mm ou 200mm ou 220mm,
- h'2 distance entre le bord inférieur et la limite inférieure de la zone centrale transparence côté conducteur (ou copilote si écran AMOLED de son côté) de préférence d'au moins 120mm et même de plus de 150mm ou 300mm
- Hₐ distance entre le bord supérieur et la limite supérieure de la zone centrale de transparence dans la partie centrale (pour écran AMOLED en position centrale), de préférence d'au moins 180mm et même d'au moins 250mm ou 300mm,
- h5 distance entre le bord latéral (gauche ou droit) et la limite latérale de la zone centrale de transparence côté conducteur (ou côté copilote si écran AMOLED de son côté) de préférence d'au moins 80mm et même de plus de 120 ou 150mm.

La hauteur h6 de la zone B réduite en position haute (entre la zone potentiellement opaque et la zone A la plus centrale) peut être de 60mm à 90mm. Elle peut servir pour un écran AMOLED (assez) transparent (qui peut remonter dans la zone potentiellement opaque). De préférence la couche de masquage externe est plus haute que l'écran AMOLED.
La hauteur h'6 de la zone B réduite en position basse (entre la zone potentiellement opaque et la zone A plus la centrale) peut être entre 60mm et 90mm. Elle peut servir pour un écran AMOLED (assez) transparent (qui peut descendre dans la zone potentiellement opaque). De préférence la couche de masquage externe est plus basse que l'écran AMOLED.

La zone de couche de masquage externe est de préférence au moins aussi grande que la surface de l'écran AMOLED, de préférence un peu plus grande :
- par exemple d'au moins 5mm de chaque côté de l'écran AMOLED
- et/ou par exemple d'au moins 5mm sous le bord le plus central (bord bas si position en haut de l'écran AMOLED, bord bas si position en bas de l'écran AMOLED).

La couche de masquage externe peut être une zone pleine (aplat) prolongée par une zone discontinue en réseau de motifs (géométriques, forme ronde, carré, rectangulaire etc) de préférence en dégradé en direction du centre du vitrage feuilleté (pare-brise).Le dégradé peut être de largeur d'au plus 15mm et même d'au plus 10mm et d'au moins 3 ou 5mm. Le dégradé peut être dans la zone du bord longitudinal inférieure de largeur d'au plus 30mm et même d'au plus 25mm et d'au moins 10 ou 15mm. De préférence l'écran AMOLED n'est pas derrière le dégradé mais derrière la zone pleine. A la limite seul le dégradé peut dépasser de l'écran AMOLED.

On peut avec plusieurs zones de masquages élargies le long d'un bord de référence ou de bords distincts et même une zone de masquage élargie dédié donc pour chaque écran AMOLED.

Le vitrage feuilleté notamment un pare-brise de véhicule routier (automobile) de forme rectangulaire peut être :
- de largeur (dimension horizontale) Lp d'au moins 1200mm et d'au plus 1850mm et de préférence de 1350 à1550mm.
- de hauteur (dimension verticale) Hp d'au moins 800mm et d'au plus 1400mm et de préférence de 950 à 1050mm.

De préférence l'écran AMOLED (dans un pare-brise de véhicule routier, automobile) est au moins de 80mm par 120mm.
De préférence on ajuste la hauteur H3 (et W3) de l'écran AMOLED dans un pare-brise de véhicule routier, automobile) en fonction de la norme en vigueur.
De préférence la largeur W3 de l'écran AMOLED dans un pare-brise de véhicule routier, automobile) agencé horizontalement en position haute (bord supérieur) est d'au moins 100mm et mieux d'au moins 120mm et même supérieure à 200mm, à 350mm, et même supérieure ou égale à 500mm, notamment ou sur toute la zone côté conducteur entre un premier bord latéral visible et la zone centrale haute (et même tout ou partie de zone centrale haute inclus) ou toute la zone côté copilote entre le deuxième bord latéral visible et la zone centrale haute (et même tout ou partie de zone centrale haute inclus).
De préférence la hauteur H3 de l'écran AMOLED dans un pare-brise de véhicule routier, automobile) agencé horizontalement en position haute (bord supérieur) est d'au moins 80mm et mieux d'au moins 100mm
De préférence la largeur W3 de l'écran AMOLED dans un pare-brise de véhicule routier, automobile) agencé horizontalement en position basse (bord inférieur) est d'au moins 100mm et mieux d'au moins 120mm et même supérieure à 200mm, à 350mm et même supérieure ou égale à 500mm, notamment ou sur toute la zone côté conducteur entre le bord latéral visible et une zone du milieu (et même tout ou partie de zone centrale basse inclus)) ou toute la zone côté copilote entre le deuxième bord latéral visible et la zone centrale basse (et même tout ou partie de zone centrale basse inclus).
De préférence la hauteur H3 de l'écran AMOLED dans un pare-brise de véhicule routier, automobile) agencé horizontalement en position basse (bord inférieur) est d'au moins 80mm et mieux d'au moins 100mm .

De préférence la largeur W3 de l'écran AMOLED dans un pare-brise de véhicule routier, automobile) agencé verticalement en position haute (bord supérieur) dans la zone centrale est d'au moins 100mm et mieux d'au moins 120mm jusqu'à 280mm ou même 300mm
De préférence la hauteur H3 de l'écran AMOLED dans un pare-brise de véhicule routier, automobile) agencé verticalement en position haute (bord supérieur) dans la zone centrale est d'au moins 80mm et mieux d'au moins 100mm et même d'au moins 150mm et jusqu'à 200mm.

Le deuxième vitrage comporte de préférence une encoche locale. L'élément de connexion sort du chant du deuxième vitrage via l'encoche de largeur de préférence d'au moins la largeur de l'élément de connexion et de préférence d'au plus la largeur de l'écran AMOLED (non inclus les rayons du façonnage).
Les dimensions de l'encoche sont donc adaptées:
- largeur de l'encoche supérieure ou égale à celle de l'élément de connexion;
- profondeur de l'encoche supérieure ou égale à l'épaisseur de l'élément de connexion pour éviter qu'il soit visible de l'extérieur en cas de bord apparent.
En pratique la profondeur de l'encoche est de préférence de 1,5mm à 3 ou même à 2mm.
La zone d'encoche est de préférence dépourvue (sensiblement) d'intercalaire de feuilletage.

L'intercalaire de feuilletage en matière polymérique est choisie parmi les polyvinylbutyral, éthylène - acétate de vinyle, polyuréthane ou résine ionomère, seuls ou en mélanges de plusieurs variétés de l'un d'eux et/ou de plusieurs d'entre eux ; le terme « variétés » fait ici référence à des variations du taux de plastifiant, de ramifications/linéarité, masse moléculaire moyenne des molécules...
Pour assurer une bonne étanchéité à l'eau, il entoure et est en contact avec l'écran AMOLED (tranche et face avant et arrière) voire même de l'élément de connexion électrique de type connecteur plat.

L'intercalaire de feuilletage lui peut être en en polyvinylbutyral (PVB), en polyuréthane (PU), en copolymère éthylène/acétate de vinyle (EVA), formé à partir d'un ou plusieurs films, ayant par exemple une épaisseur entre 0,2mm et 1,1mm.
La surface de l'intercalaire de feuilletage peut être inférieure à la surface du vitrage feuilleté, par exemple laissant une gorge (en cadre ou en bandeau), libre donc non feuilletée.

Le premier vitrage comme le deuxième vitrage peut être parallélépipédique, avec des feuilles ou des faces principales rectangulaires, carrées ou même de toute autre forme (ronde, ovale, polygonale).
Le premier et/ou deuxième vitrage peut (selon le rendu esthétique, l'effet optique souhaité) être un verre clair (de transmission lumineuse T_{L} supérieure ou égale à 90% pour une épaisseur de 4mm), par exemple un verre de composition standard sodocalcique comme le Planilux® de la société Saint-Gobain Glass, ou extra-clair (T_{L} supérieure ou égale à 91,5% pour une épaisseur de 4 mm), par exemple un verre silico-sodo-calcique avec moins de 0,05% de Fe III ou de Fe₂O₃ comme le verre Diamant® de Saint-Gobain Glass, ou Optiwhite® de Pilkington, ou B270® de Schott, ou d'autre composition décrite dans le document WO04/025334.
Le verre du premier et/ou deuxième vitrage peut être neutre (sans coloration), ou (légèrement) teinté notamment gris ou vert, tel le verre TSA de la société Saint-Gobain Glass. Le verre du premier et/ou deuxième vitrage peut avoir subi un traitement chimique ou thermique du type durcissement, recuit ou une trempe (pour une meilleure résistance mécanique notamment) ou être semi trempé.
La transmission lumineuse T_{L} peut être mesurée selon la norme ISO 9050 :2003 en utilisant l'illuminant D65, et est la transmission totale (notamment intégrée dans le domaine du visible et pondérée par la courbe de sensibilité de l'œil humain), tenant compte à la fois de la transmission directe et de l'éventuelle transmission diffuse, la mesure étant faite par exemple à l'aide d'un spectrophotomètre muni d'une sphère intégrante, la mesure à une épaisseur donnée étant ensuite convertie le cas échéant à l'épaisseur de référence de 4mm selon la norme ISO 9050 :2003.
Pour un vitrage feuilleté de véhicule notamment pare-brise ou vitrage latéral, la T_{L} peut être de préférence d'au moins 70% et même d'au moins 75% ou 80%.
Dans une réalisation le premier vitrage est en verre minéral et le deuxième vitrage est en verre organique (comme le PC, le PMMA, le copolymère cyclo-oléfine (COC) ou encore le polyéthylène téraphtalate (PET) éventuellement protégé par un revêtement (en face F4).

Le vitrage extérieur peut comporter des couches minces fonctionnelles sur l'une ou l'autre de ses faces F1 et F2 ou bien les deux : on peut citer une couche hydrophobe ou autonettoyante photocatalytique en face F1.

De préférence le vitrage feuilleté forme un pare-brise de véhicule routier tel qu'une automobile, un camion, avec les premier et deuxième vitrage bombés et même un intercalaire de feuilletage en PVB. Le bombage des premier et deuxième vitrages (pare-brise) peut être dans une ou plusieurs directions par exemple comme décrit dans le document WO2010136702.

L'écran AMOLED peut avoir de préférence une épaisseur d'au plus 0,8 mm, de préférence au plus égale à 0,7mm, et de manière particulièrement préférée au plus égale à 0,6 mm et même d'au moins 0,15mm .

L'écran AMOLED comporte de préférence un support flexible (polymérique, verre voire un métal) porteur d'une électrode dite inférieure (souvent l'anode) d'un système électroluminescent organique et d'une électrode supérieure, en incluant une matrice de transistors en couches minces ('TFT' en anglais). D'autres éléments ou couches fonctionnelles sont possibles notamment :
- entre le support et l'électrode inférieure et sous forme de dépôt ou de film : couche barrière (à l'oxygène, l'humidité etc),
- sur l'électrode supérieure et sous forme de dépôt ou de film : couche de protection (à l'oxygène, l'humidité etc), par exemple dépôt (vernis, enrobage, en résine etc) et/ou film de façade (film polymérique transparent : PET etc).

Plus précisément le pixel comporte de préférence cote à cote deux ou trois des systèmes suivants :
- un système électroluminescent organique émettant dans le rouge dit « R »,
- un système électroluminescent organique émettant dans le vert dit « G »,
- un système électroluminescent organique émettant dans le bleu dit « B »,
- un système électroluminescent organique émettant dans le blanc dit « W » ;
en particulier RGB,RWB,WBG,RWB,W,BG.
Le nombre de pixels est d'au moins 64x128. L'émission est de type top émitting (émission à l'opposé du substrat). On entend par face avant la face de visualisation.

On peut prévoir des moyens de modulation de la puissance de l'écran AMOLED selon au moins deux configurations : une configuration pour la vision nocturne, dans laquelle la puissance de l'écran AMOLED est ajustée pour que la luminance soit typiquement comprise entre environ 10 et environ 400Cd/m² et une configuration pour la vision diurne, dans laquelle la puissance de l'écran AMOLED est ajustée pour que la luminance soit typiquement comprise entre environ 10 et environ 500Cd/m². En vision diurne, on peut aussi ajuster la luminance de l'écran AMOLED en fonction de l'éclairement extérieur.

Toutes informations peuvent être affichées sur l'écran AMOLED (notamment sur un pare-brise): conditions atmosphériques extérieures et intérieures, vision de l'environnement arrière, vision de l'environnement latéral gauche et droite (come déjà indiqué), informations liées aux conditions de conduite et panneaux de signalisation, informations techniques relatives au véhicule de transport.

L'écran AMOLED en particulier peut avoir l'une ou les fonctions suivantes (cumulables)
- vison centrale de l'arrière
- affichage d'informations d'aide à la conduite, en particulier alerte, détection d'obstacles,
- affichage d'informations (niveaux, état de fonctionnement, d'usure, etc) sur les caractéristiques du véhicule (moteur, roues, freins, phares etc), en particulier en cas d'alerte (avec un arrêt demandé)
- affichage d'informations sur l'environnement extérieur : météo, distance d'une station-service (d'un point électricité etc), d'une ville, d'une sortie d'autoroute
- affichage d'informations sur la connectivité : accès au réseau (réseau social, internet etc)
- fonctionnement en mode téléphonique : affichage de l'interlocuteur, d'un personne (police, milieu médical) en cas d'urgence et/ou d'accident ou de situation à risque

L'écran AMOLED et/ou un autre écran AMOLED peut aussi faire office de TV coté copilote, ou de fonctionnement en mode téléphonique : affichage de l'interlocuteur, d'un personne (police, milieu médical) en cas d'urgence et/ou d'accident ou de situation à risque.
L'écran AMOLED peut afficher plusieurs images comme dans une télévision
- image principale (vision centrale de l'arrière etc)
- image(s) incrustée(s) (vision latérale du véhicule etc).
L'écran AMOLED est notamment rectangulaire ou carré.
Côté face avant, au moins une frange périphérique dite bord technique de l'écran AMOLED (zone distincte de la zone active, d'affichage) peut être masquée par une couche de masquage dite interne, de préférence en émail, sur la face F3 ou F4 ou par un élément de masquage (film, couche opaque) sur la face avant. Et/ou la surface avant de l'élément de connexion (la partie de connectique) peut être masquée par une (même) couche de masquage dite interne, de préférence en émail, sur la face F3 ou F4 ou par un élément de masquage (film opaque) sur la surface avant.
La couche de masquage interne est éventuellement un aplat avec une ouverture laissant apparente la zone d'affichage et de largeur inférieure ou égale à la largeur de la couche de masquage externe.
La couche de masquage interne peut former non seulement :
- un masquage de la partie de connectique, opaque ou faiblement transparent,
- ainsi qu'un masquage des bords techniques de l'écran AMOLED, vus du côté intérieur du vitrage, notamment du pare-brise,
- et même, en dépassant du ou des bords techniques, de la jonction entre l'intercalaire de feuilletage et l'écran AMOLED, jonction qui peut comporter des irrégularités et failles, (et même de la jonction entre l'intercalaire de feuilletage et la partie de connectique).
L'élément de masquage peut faire partie d'un film de support et/ou protection tel que polytéréphtalate d'éthylène (PET) de l'écran AMOLED et de la partie de connectique. Le film opaque peut être mis en adhésion avec l'ensemble de l'écran AMOLED et de la partie de connectique dès son prémontage en vue de son stockage, ou bien faire partie d'un film qui a été mis en adhésion avec cet ensemble prémonté, film dont on peut alors éventuellement éliminer une partie non désirée prédécoupée avant l'assemblage du pare-brise.
L'élément de masquage (film opaque etc) peut former non seulement :
- un masquage de la partie de connectique, opaque ou faiblement transparent,
- ainsi qu'un masquage des bords techniques de l'écran AMOLED, vus du côté intérieur du pare-brise,
- et même, en dépassant du ou des bords techniques, de la jonction entre l'intercalaire de feuilletage et l'écran AMOLED, jonction qui peut comporter des irrégularités et failles, (et même de la jonction entre l'intercalaire de feuilletage et la partie de connectique).
Le film opaque peut aussi être un prolongement opacifié du matériau polymère transparent recouvrant l'écran AMOLED, c'est-à-dire en être partie intégrante.
Le film opaque peut aussi alternativement ou cumulativement être un prolongement du matériau polymère recouvrant la partie de connectique, c'est-à-dire en être partie intégrante.

La couche de masquage interne ou l'élément de masquage (le film opaque) peuvent dépasser des bords techniques d'au moins 0,1 mm et même d'au plus 5mm ou 2mm. Les deux réalisations couche de masquage interne/élément de masquage ne s'excluent pas nécessairement l'une l'autre, et l'on peut imaginer un masquage du bord technique de l'écran AMOLED selon la première réalisation et un masquage de l'élément de connexion (la partie de connectique) selon la seconde, ou un double masquage du bord technique de l'écran AMOLED ou de l'élément de connexion selon les deux réalisations à la fois.
Le masquage a pour fonction de cacher des parties inutiles et disgracieuses du dispositif pour n'en laisser visible de l'intérieur que la partie utile ; tout procédé adapté à la nature du substrat selon la première ou seconde réalisation, peut être employé : impression telle que jet d'encre, sérigraphie, émail comme sur la face F2....

La couche de masquage interne peut se cantonner à masquer le ou les bords techniques et une partie (au moins celle visible) de l'élément de connexion électrique (de la partie de connectique), ou même dépasser éventuellement un peu d'au plus 1 à 2cm. La couche de masquage interne peut être dans la zone avec l'écran AMOLED de largeur inférieure ou égale à celle du masquage externe de sorte que le masquage externe est visible par transparence de part et d'autre de l'écran AMOLED.
Une couche de masquage interne et/ou externe peut être une couche d'émail foncé (noir), mais plus largement une couche de peinture ou encre opaque, ou une couche de polymère peinte (ex. PVB imprimé), par exemple en polyéthylène, en polyméthacrylate de méthyle (PMMA).
La couche de masquage externe en face F2 et celle interne en F3 ou F4 sont de préférence constituées du même matériau et même en émail. On préfère avoir une couche en émail au moins en face F2 et même en face F4.

La présente invention sera mieux comprise et d'autres détails et caractéristiques avantageuses de l'invention apparaitront à la lecture des exemples de vitrages feuilletés de véhicule selon l'invention illustrés par les figures suivantes :

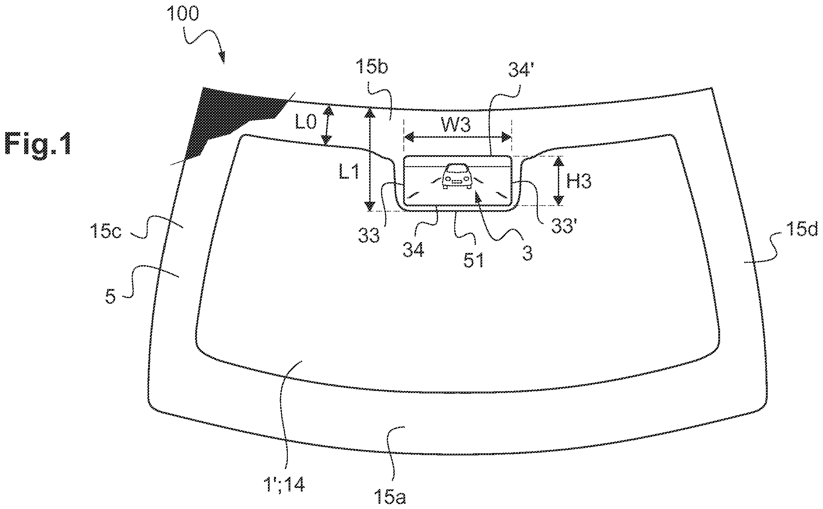

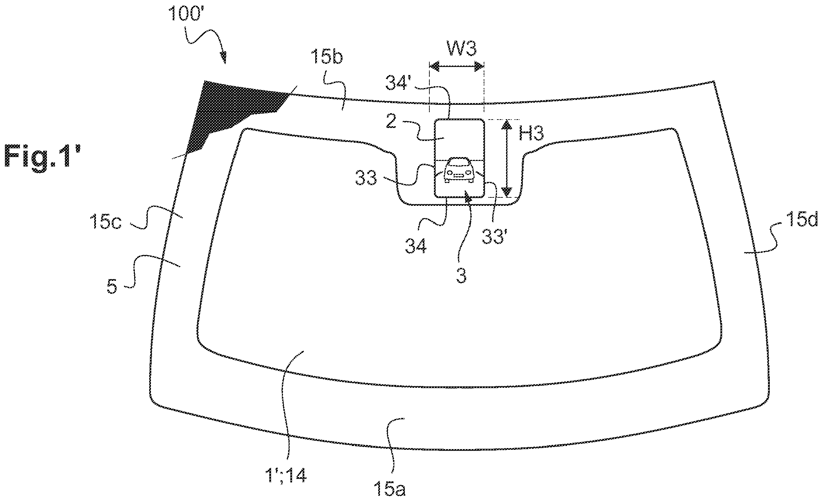

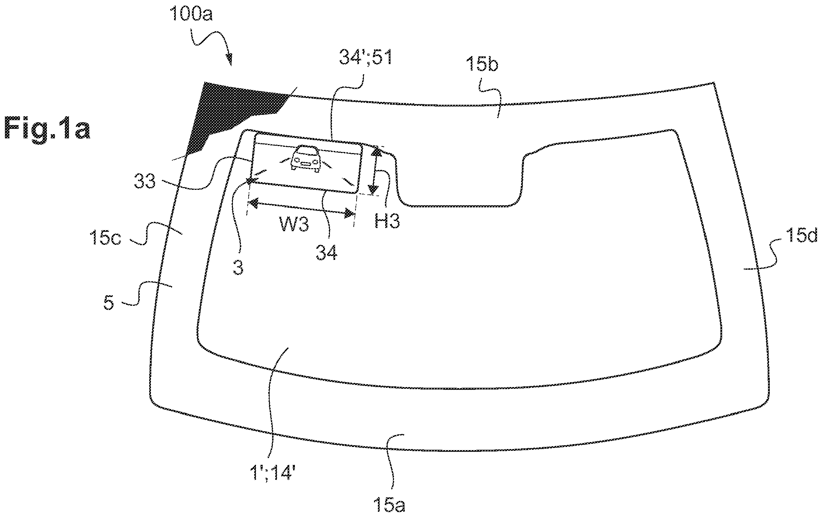

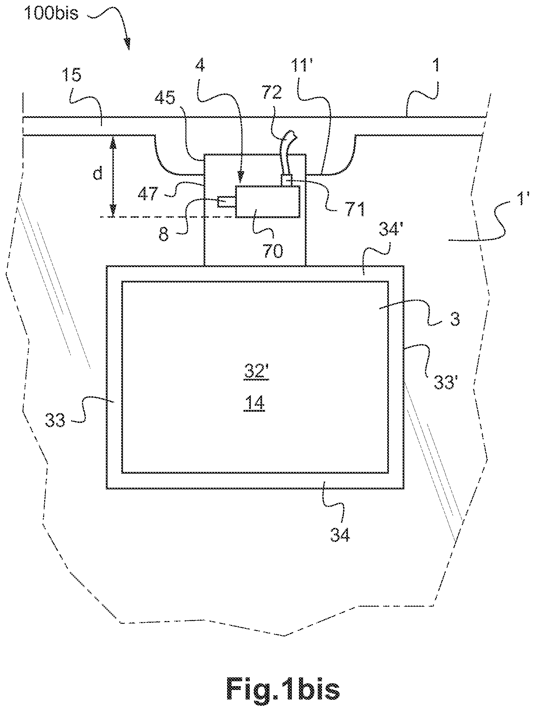

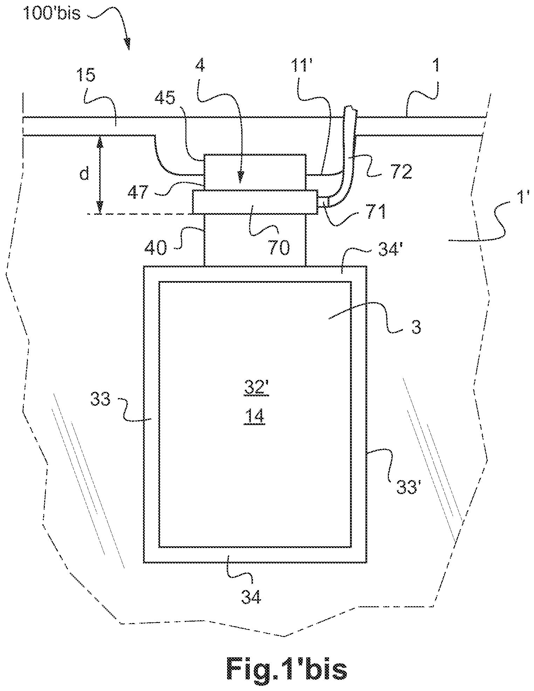

- les Figures 1, 1' ,1a, et 8 sont chacune une vue schématique de face d'un pare-brise avec écran AMOLED d'un véhicule automobile, vue côté intérieur
- les Figures 1 bis, 1'bis sont des vues schématiques de face et de détail d'un pare-brise avec écran AMOLED d'un véhicule automobile, vue côté intérieur
- les Figures 2, 3, 4, 5, 6, 7 sont des vues schématiques en coupe et partielle d'un pare-brise avec écran AMOLED d'un véhicule automobile, vue côté intérieur.

On précise que par un souci de clarté les différents éléments des objets représentés ne sont pas nécessairement reproduits à l'échelle. Par simplification, les vitrages ne sont pas représentés bombés ni les éléments flexibles dans le feuilletage courbés en s'adaptant à cette ou ces courbures (selon deux dimensions) de vitrage.

La Figure 1 est une représentation schématique partielle vue de l'intérieur d'un pare-brise avec écran AMOLED 100 d'un véhicule automobile.
Le pare-brise 100 comprend une zone centrale de clair de vue (partie centrale du vitrage intérieur 1' donc côte face F4 14) et une cadre périphérique de masquage externe 5, des bords longitudinaux bas 15a et haut 15b, latéraux gauche 15c et droit 15d, cadre masquant ici l'arrière de l'écran AMOLED 3 opaque ou faiblement transparent (pas assez transparent pour être dans le clair de vitre). La couche de masquage externe 5, en face F2, cache ainsi d'une vue de l'extérieur du véhicule l'écran AMOLED 3 (et son connecteur non représenté ici, de préférence dans le feuilleté). L'émail 5 a pour fonction première de cacher, vus de la face F1, le cordon de colle solidarisant le vitrage feuilleté final à la baie de carrosserie.
L'écran AMOLED est agencé en position centrale du bord longitudinal haut 15b de manière horizontale et est rectangulaire. Il est (tout ou partie) dans une zone dite élargie dont la largeur (dimension verticale) L1 de l'émail est plus grande que la largeur L0 adjacente (par exemple à gauche) servant pour le masquage classique et même côté copilote.
Par exemple, la dimension horizontale ou largeur W3 est d'au moins 120mm et même jusqu'à 250mm. La dimension verticale ou hauteur H3 est d'au moins 75 mm.
L'écran AMOLED 3 est ici descendu au plus bas de la zone périphérique élargie. Son bord bas 34 est à proximité ou sur la frontière de l'aplat d'émail 51 (zone pleine) plutôt que sur la frontière de la zone éventuelle avec des motifs d'émail par exemple de largeur d'au plus 15mm. Son bord haut 34' peut être le plus haut possible (à la limite de la zone de vision dans l'habitacle), typiquement d'au moins 15mm et mieux d'au moins 70mm. Cela dépend de la conception du pare-brise (taille, inclinaison, clair de vue souhaité par le constructeur).
Les bords 53, 53' de la zone élargie d'émail 50 peut dépasser des bords latéraux 33 et 33' par exemple d'au plus 2 cm ou même 1 ou 0,5cm (limite de la zone pleine). A l'état off, l'écran AMOLED est sombre et même ne se distingue pas ou à peine du fond d'émail 5 (dépassant sur les côtés). On peut adapter la couleur d'émail en conséquence. De préférence l'émail est opaque et foncé.

L'écran AMOLED est ici dans une zone périphérique distincte de la zone centrale transparente dite zone A Z_{A} (la plus centrale et en deux parties, en quadrilatère) ou de la zone B réduite Z_{b} (en pointillés)
Sur l'écran AMOLED 3 allumé, on peut voir la vision centrale de l'arrière du véhicule et de préférence les visions latérales du véhicule
L'écran AMOLED peut avoir la fonction de vision de l'arrière. Il peut aussi avoir d'autres fonctions comme : mode téléphone, mode télévision, affichage de données environnementales ou sur la route (cartes, GPS etc) ou sur le véhicule, affichage simultané sur une ou des zones d'écran (par exemple à la manière d'un écran de téléphone mobile).
En variante non montrée, l'écran AMOLED est sur le bord longitudinal haut côté conducteur. Il est plus haut mais peut être plus large que dans la zone centrale et dépasser dans la zone centrale (hors zone saillante d'émail).
En variante non montrée, l'écran AMOLED est sur le bord longitudinal bas côté conducteur dans la zone de vision. Il peut être plus large que dans la zone centrale En variante non montrée, l'écran AMOLED est sur le bord latéral bas côté conducteur et est agencé verticalement au plus bas dans la zone de vision
Le boitier d'interface (en périphérie) n'est pas représenté.

La Figure 1' est une représentation schématique partielle vue de l'intérieur d'un pare-brise 100' avec écran AMOLED d'un véhicule automobile.
Le pare-brise 100' diffère de celui en figure 1 en ce que l'écran AMOLED est agencé de manière verticale (H3 plus grand et W3 moins grande).Par exemple H3 est de 150 mm à 300mm et W3 de 60m à 120mm.
Le boitier d'interface (en périphérie) n'est pas représenté.
En variante non montrée, on dispose dans cette zone centrale deux écrans AMOLED de part et d'autre de l'écran AMOLED :
- par exemple agencés également de manière verticale
- par exemple agencés de manière horizontale

La Figure 1a est une représentation schématique partielle vue de l'intérieur d'un pare-brise 100a avec écran AMOLED d'un véhicule automobile.
Le pare-brise 100a diffère de celui en figure 1 en ce que l'écran AMOLED est agencé dans une zone transparente (exigée) par exemple avec le bord haut 34' à la limite de la zone pleine 51. Le boitier d'interface (en périphérie) n'est pas représenté.

La Figure 1bis est une vue schématique de face et de détail d'un pare-brise 100bis avec écran AMOLED d'un véhicule automobile, vue côté intérieur.
Par simplification la couche de masquage extérieur n'est pas représentée alors qu'elle couvre la zone de l'écran AMOLED (qui est en périphérie, opaque ou faiblement transparent). Les éléments en traits pleins sont vus par transparence au travers du vitrage intérieur1'.
Comme en figure 1, l'écran AMOLED 3 est agencé horizontalement dans la zone centrale du bord longitudinal haut 15b. Le pare-brise 100bis comprend une feuille de verre minéral extérieure 1 et une feuille de verre minéral intérieure 1' dont le bord supérieur 15b présente une encoche 11'.
L'écran AMOLED 3 est pris en sandwich entre la feuille de verre extérieure 1 et la feuille de verre intérieure 1'. Il présente une zone d'affichage 32' encadrée par un ou des bords techniques (ici quatre) en des étroites franges périphériques latérales 33 et 33', basse 34, haute 34' de largeur généralement de 0,5mm au moins. Il est alimenté par un élément de connexion électrique 4 de l'écran AMOLED 3 qui comporte :
- une partie flexible dite de connectique 40 entre la face F2 et la face F3 au sein de l'intercalaire de feuilletage avec une surface avant côté face F3 et une surface arrière côté face F2, d'épaisseur E4 inférieure à celle E2 de l'intercalaire de feuilletage, reliée à l'écran AMOLED et prolongeant l'écran AMOLED en direction du chant du deuxième vitrage,
- prolongée hors du chant du deuxième vitrage par une partie dite extérieure 45 flexible, courbée et fixée par collage en face F4 sans s'étendre jusqu'à la zone d'affichage 32' via une partie dite terminale 47 terminée par son connecteur 8 dans une zone accessible au moment du montage/ démontage.
L'élément de connexion 4 est un circuit imprimé flexible (en anglais : « Flexible Printed Circuit » - FPC) apte à la mise en oeuvre de 2560 X 1600 pixels (écran AMOLED). Le FPC 4 pourrait aussi avantageusement être de même largeur que l'écran AMOLED 3, de manière à faciliter l'insertion des deux éléments dans l'intercalaire de feuilletage de préférence en polyvinylbutyral (PVB un peu en retrait par rapport aux bords de vitrage). Le verre intérieur 1' comporte une encoche 11'. Les dimensions de l'encoche 11' sont adaptées au FPC 4 :
- largeur de l'encoche 11' supérieure ou égale à celle du FPC 4 ;
- profondeur de l'encoche 11' supérieure ou égale à l'épaisseur du FPC 4 de préférence pour éviter que le FPC 4 soit visible de l'extérieur en cas de bord apparent.
En pratique la profondeur de l'encoche 11' est comprise entre 1,5mm et 2mm. La zone de l'encoche 11' est dépourvue sensiblement d'intercalaire de feuilletage.

Le boitier d'interface 70 par exemple parallélépipédique est connecté au connecteur 8 ici sur un bord latéral et sur un autre bord (ici longitudinal) à un connecteur 71 d'un câble d'alimentation électrique 72. d est par exemple de quelques cm.

La Figure 1'bis.est une vue schématique de face et de détail d'un pare-brise 100'bis avec écran AMOLED d'un véhicule automobile, vue côté intérieur. Par simplification la couche de masquage extérieur n'est pas représentée alors qu'elle couvre la zone de l'écran AMOLED (en périphérie, opaque ou faiblement transparent). Les éléments en traits pleins sont vus par transparence au travers du vitrage intérieur1 '.
Il diffère du pare-brise 100bis par son agencement à la verticale.
Le boitier d'interface 70 par exemple parallélépipédique est monté sur la partie terminale 47 et connecté sur un bord (ici latéral) à un connecteur 71 d'un câble d'alimentation électrique 72. d est par exemple de quelques cm.

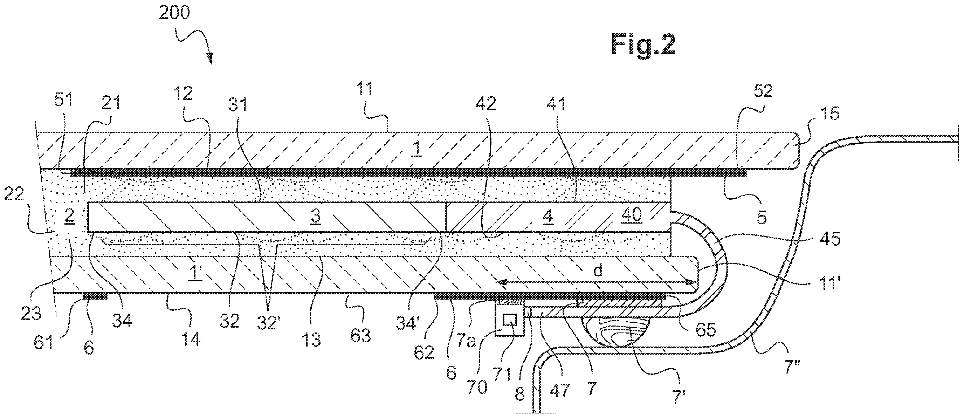

La Figure 2 est une vue schématique en coupe et partielle d'un pare-brise 200 avec écran AMOLED d'un véhicule automobile, vue côté intérieur.
Le pare-brise 200 comporte :
- un premier vitrage 1, avec une première face principale 11 dite F1, destinée à être coté extérieur du véhicule, et une deuxième face principale opposée 12 dite F2, de préférence d'épaisseur E1 d'au plus 2,5mm, en particulier une feuille de verre flotté silicosodocalcique de préférence teinté, de 2,1mm d'épaisseur de verre comme un verre TSA de la société Demanderesse
- un intercalaire de feuilletage en matière polymérique 2, côté face F2, d'épaisseur E2 de préférence d'au moins 0,76mm comme du polyvinylbutyral (PVB)
- un deuxième vitrage 1', avec une troisième face principale 13 dite F3 coté intercalaire de feuilletage 2 et une quatrième face principale opposée 14 dite F4, destinée à être coté intérieur du véhicule, de préférence d'épaisseur E'1 d'au plus 2,2mm, en particulier une feuille de verre flotté silicosodocalcique de 1,6mm d'épaisseur de verre, par exemple teinté comme un verre TSA de la société Demanderesse,
- entre la face F2 et la face F3 et au sein de l'intercalaire de feuilletage, un écran de visualisation à diode électroluminescente organique, comportant un ensemble de pixels, dit écran AMOLED 3, flexible, l'écran AMOLED comportant une zone d'affichage d'informations en dynamique 32', d'épaisseur E3 inférieure à E2 et de préférence subcentimétrique, écran AMOLED ayant une face principale avant 32 orientée vers la face F3 et une face arrière 31 orientée vers la face F2, l'écran AMOLED est agencé en périphérie,
- au sein de l'intercalaire de feuilletage un élément de connexion électrique 4 de l'écran AMOLED.

L'écran OLED 3 est donc pris en sandwich entre la feuille de verre extérieure 1 et la feuille de verre intérieure 1'. Il présente une zone d'affichage 32' encadrée par un ou des bords techniques i un, deux, trois ou quatre) en des étroites franges périphériques 34, 34' de largeur généralement de 0,5mm au moins (et inférieure à 1cm de préférence). L'écran AMOLED 3, flexible et directement prolongé vers un bord du vitrage, par l'élément de connexion 4 qui lui est relié et se prolonge hors feuilletage.
Il est alimenté par un élément de connexion électrique 4 de l'écran AMOLED 3 qui comporte :
- une partie flexible dite de connectique 40 entre la face F2 et la face F3 au sein de l'intercalaire de feuilletage avec une surface avant 42 côté face F3 et une surface arrière 41 côté face F2, d'épaisseur E4 inférieure à celle E2 de l'intercalaire de feuilletage reliée à l'écran AMOLED et prolongeant l'écran AMOLED en direction du chant du deuxième vitrage 1',
- prolongée hors du chant du deuxième vitrage via une partie dite extérieure 45 courbé et fixé par collage (en face F4 sans s'étendre jusqu'à la zone d'affichage 32' via une partie terminale 47 terminée par son connecteur 8 dans une zone accessible au moment du montage/ démontage.
L'élément de connexion 4 est un circuit imprimé flexible (en anglais : « Flexible Printed Circuit » - FPC) apte à la mise en oeuvre de 2560 X 1600 pixels (écran AMOLED). Le FPC 4 pourrait avantageusement être de même largeur que l'écran AMOLED 3, de manière à faciliter l'insertion des deux éléments dans l'intercalaire de feuilletage (un peu en retrait par rapport aux bords de vitrage).
Le verre intérieur 1' comporte une encoche 11'. Les dimensions de l'encoche 11' sont adaptées au FPC 4 :
- largeur de l'encoche 11' supérieure ou égale à celle du FPC 4 ;
- profondeur de l'encoche 11' supérieure ou égale à l'épaisseur du FPC 4 de préférence pour éviter que le FPC 4 soit visible de l'extérieur en cas de bord apparent.
En pratique la profondeur de l'encoche 11' est comprise entre 1,5mm et 2mm. La zone de l'encoche 11' est dépourvue sensiblement d'intercalaire de feuilletage.
Le boitier d'interface 70 collé par adhésif 7a (sensible à la pression etc) sur la face F4 14 est par exemple parallélépipédique est connecté au connecteur 8 ici sur un bord longitudinal et sur un autre bord (ici latéral) à un connecteur 71 d'un câble d'alimentation électrique (non montré). d est par exemple de quelques cm.
L'écran AMOLED 3 a par exemple une épaisseur E3. La partie de connectique 40 peut être moins épaisse. Elle est éventuellement recouverte ou enrobée de tout matériau pour en augmenter (si nécessaire) l'épaisseur E4 à une valeur sensiblement égale à E3. Si E4 est égale de 0,4mm, E3 est de 0,38 à 0,40mm. On utilise par exemple pour le feuilletage un feuillet central 22 de 0,38mm avec une réserve pour loger l'écran AMOLED et la partie de connectique et deux feuillets externes 22, 23 de 0,17mm ou 0,38mm. L'un des feuillets externes peut être plus épais par exemple 0,76mm.
On peut avoir plus que 3 feuillets (si insertion d'un film polymérique comme un PET etc) ou pour plus de protection mécanique.
Lorsque l'écran AMOLED est d'épaisseur d'au plus 0,15mm ou même 0,2mm on peut éventuellement supprimer le feuillet central à l'assemblage.
Le premier vitrage (extérieur) 1 comporte une couche de masquage externe 5 en face F2, opaque, en émail noir de préférence,
- avec un bord 51 vers le centre du pare-brise
- et un bord 52 côté chant du vitrage 15 par exemple distant d'au plus 3 ou 1mm du chant 15.
Elle cache non seulement le cordon de colle 7' de la garniture 7" mais aussi l'écran AMOLED 3 (opaque ou faiblement transparent), la partie de connectique 40 et la partie hors vitrage 45 du FPC et la partie 47 et son connecteur 8.
La couche de masquage externe 5 est de préférence une zone pleine (un aplat) plutôt qu'un réseau de motifs. Au-delà du bord 51 elle peut être prolongée par un réseau de motifs (en même matière) par exemple en dégradé sur une largeur d'au plus 15mm et même 5mm et même plus grande si le chant 15 est le bord longitudinal inférieur.
Le deuxième vitrage 1' (intérieur) comporte en face F4 une couche de masquage interne 6 en face F4 (ou en variante F3), opaque, en émail noir de préférence, avec
- un bord 61 vers le centre du pare-brise
- un bord 65 côté encoche.
Cette couche de masquage interne 6 masque de l'intérieur toute la surface de la partie de connectique 40 en particulier celle qui est dans la zone de vision (hors zone avec garniture ou éventuel boitier).Elle peut être plus large que la partie de connectique. Cette couche de masquage interne masque également de l'intérieur les bords techniques 34, 34' de l'écran AMOLED. Elle peut dépasser par exemple d'au plus 10mm en regard de l'intercalaire de feuilletage sur le pourtour des bords techniques pour masquer des défauts de feuilletage.

Lorsque la couche de masquage interne 6 est ainsi sur le pourtour de l'écran AMOLED 3, on a donc formé une ouverture 63 (masquage ou post fabrication de la couche) laissant apparente la zone d'affichage 32'.
Elle peut aussi dépasser plus largement des bords techniques pour être de largeur (quasi égale) à celle de la couche de masquage externe 5 de part et d'autre de l'écran AMOLED (et/ou de la partie de connectique).
La couche de masquage interne 6 est de préférence une zone pleine (un aplat) plutôt qu'un réseau de motifs. Au-delà du bord 61 elle peut être prolongée par un réseau de motifs (en même matière) par exemple en dégradé sur une largeur d'au plus 15mm et même 5mm et même plus grande si le chant de l'encoche 11' est le bord longitudinal inférieur.

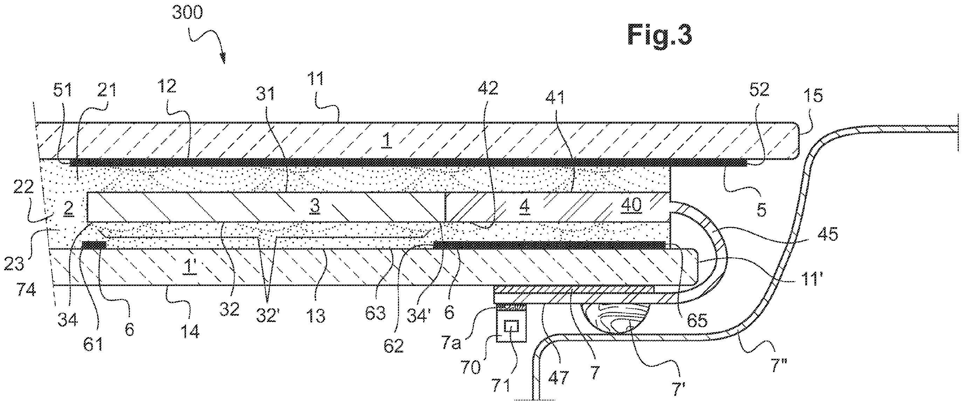

La Figure 3 est une vue schématique en coupe et partielle d'un pare-brise 300 avec écran AMOLED d'un véhicule automobile, vue côté intérieur.
Le pare-brise 300 diffère du pare-brise 200 d'abord en ce que la couche de masquage interne est en face F3 au lieu de face F4.
Le boitier d'interface 70 par exemple parallélépipédique est monté par collage 7a (adhésif, sensible à la pression etc) sur la partie terminale 47 et connecté sur un bord (ici latéral) à un connecteur 71 d'un câble d'alimentation électrique (non montré). d est par exemple de quelques cm.
On peut augmenter la largeur de l'adhésif 7.

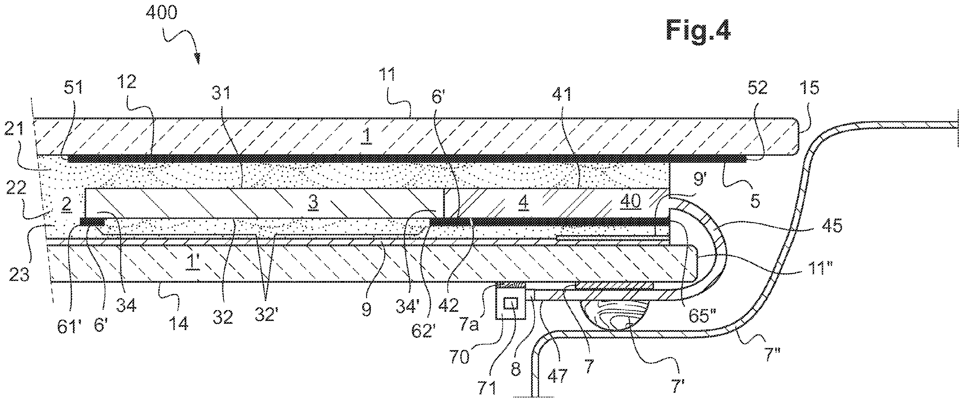

La Figure 4 est une vue schématique en coupe et partielle d'un pare-brise 400 avec écran AMOLED d'un véhicule automobile, vue côté intérieur.
Il diffère du pare-brise 200 en ce que la couche de masquage interne 6 est remplacé par d'un film opaque (opacifié) 6' de polytéréphtalate d'éthylène (PET) pouvant être mise en adhésion avec l'ensemble de l'écran AMOLED 3 et du FPC 4 dès son prémontage en vue de son stockage, ou bien faire partie d'un film qui a été mis en adhésion avec cet ensemble prémonté, film dont on peut alors éventuellement éliminer une partie non désirée prédécoupée avant l'assemblage du pare-brise.
Le film opaque 6' constitue :
- un masquage du FPC 40, opaque ou faiblement transparent, et de la jonction entre le PVB 22 (partie centrale) et l'écran AMOLED 3, qui peut comporter des irrégularités et failles,
- ainsi qu'un masquage 61', 62' des bords techniques 34 de l'écran AMOLED 3, vus du côté intérieur du pare-brise.

Le film opaque 6' peut aussi être un prolongement opacifié du matériau polymère transparent recouvrant l'écran AMOLED, c'est-à-dire en être partie intégrante.
Le film opaque 6' peut aussi alternativement ou cumulativement être un prolongement du matériau polymère recouvrant le FPC, c'est-à-dire en être partie intégrante.

Par ailleurs, la face F3 est munie d'une couche électroconductrice 9 et éventuellement d'une amenée de courant 9' pour celle-ci; cette couche peut consister en un empilement réfléchissant le rayonnement solaire, à l'argent ou autre, ou d'un revêtement /empilement chauffant muni à cet effet de son amenée de courant 9'. Elle peut être recouverte directement d'un masquage du bord technique de l'écran AMOLED mentionné précédemment.

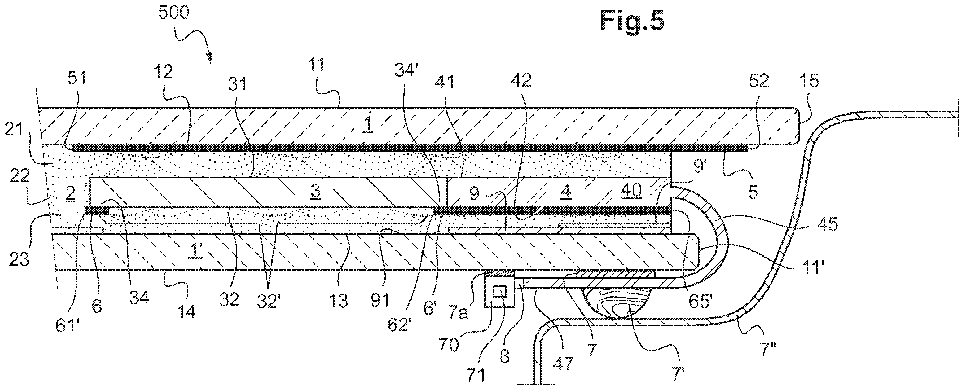

La Figure 5 est une vue schématique en coupe et partielle d'un pare-brise 500 avec écran AMOLED d'un véhicule automobile, vue côté intérieur.
Il diffère du pare-brise précédent 400 en ce que pour des raisons esthétiques la couche électroconductrice est absente au moins dans la zone 91 en regard de la zone d'affichage 32'.

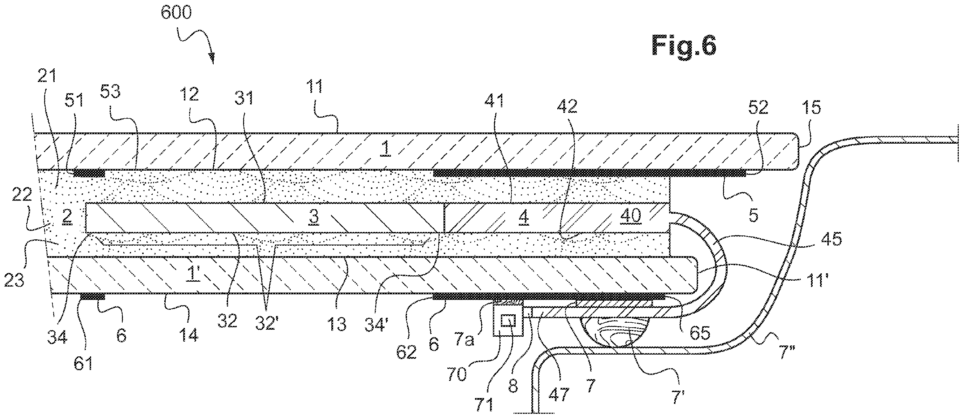

La Figure 6 est une vue schématique en coupe et partielle d'un pare-brise 600 avec écran AMOLED d'un véhicule automobile, vue côté intérieur.
Il diffère du pare-brise 200 en ce que l'écran AMOLED 3 est placé dans une zone de vision transparente dont sans couche de masquage externe 6 derrière.
Toutefois le masquage de l'extérieur des bords techniques 34, 34' (et même du PVB 22) par la couche d'émail externe 5,51 peut être accepté. Du coup la couche d'émail 5 peut avoir une ouverture 53 face à la zone d'écran AMOLED. Et le masquage de l'intérieur des bords techniques 34, 34' (et même du PVB 22) par la couche d'émail interne 6,61 peut être accepté. Du coup la couche d'émail 6 peut avoir une ouverture 63 face à la zone d'écran AMOLED.

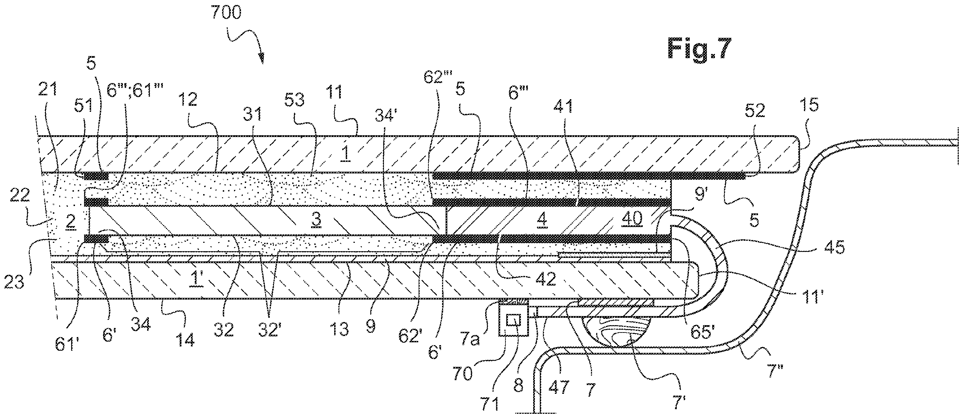

La Figure 7 est une vue schématique en coupe et partielle d'un pare-brise 700 avec écran AMOLED d'un véhicule automobile, vue côté intérieur.
Il diffère du pare-brise 600 par le remplacement de la couche de masquage interne 6 par un film opaque 6' (comme en figure 5) sur l'écran AMOLED et le FPC 40 côté avant. On peut aussi un film opaque 6" (comme en figure 5) sur l'écran AMOLED et le FPC 40 côté arrière en plus ou en remplacement de l'émail du bord 51.

## Revendications

1. Vitrage feuilleté de véhicule (100 à 800) de préférence pare-brise de véhicule routier, comportant :
- un premier vitrage (1), avec une première face principale (11) dite F1, notamment destinée à être coté extérieur du véhicule, et une deuxième face principale opposée (12) dite F2, de préférence d'épaisseur E1 d'au plus 2,5mm
- un intercalaire de feuilletage en matière polymérique (2), côté face F2, d'épaisseur E2 de préférence d'au plus 2,2mm
- un deuxième vitrage (1'), avec une troisième face principale (13) dite F3 coté intercalaire de feuilletage (2) et une quatrième face principale opposée (14) dite F4, notamment destinée à être coté intérieur du véhicule, de préférence d'épaisseur E'1 d'au plus 2,2mm, l'un au moins des premier et deuxième vitrages étant en verre minéral,
- entre la face F2 et la face F3, un écran de visualisation à diode électroluminescente organique, comportant un ensemble de pixels, dit écran AMOLED (3), l'écran AMOLED comportant une zone d'affichage d'informations en dynamique (32'), est d'épaisseur E3 inférieure à E2 et de préférence subcentimétrique, écran AMOLED ayant une face principale avant (32) orientée vers la face F3 et une face arrière (31) orientée vers la face F2, l'écran AMOLED étant couvert par une épaisseur non nulle d'intercalaire de feuilletage et de préférence au sein de l'intercalaire de feuilletage, l'écran AMOLED est notamment agencé en périphérie,
- un élément de connexion électrique (4) de l'écran AMOLED, de préférence avec une partie flexible dite de connectique (40) entre la face F2 et la face F3 avec une surface avant (42) côté face F3 et une surface arrière (41) côté face F2, partie flexible de connectique couverte par une épaisseur non nulle d'intercalaire de feuilletage et de préférence au sein de l'intercalaire de feuilletage, d'épaisseur E4 inférieure à E2 et de préférence subcentimétrique, reliée à l'écran AMOLED et prolongeant l'écran AMOLED en direction du chant du deuxième vitrage, l'élément de connexion électrique, flexible, se prolongeant alors hors du chant du deuxième vitrage via une partie dite extérieure (45),
**caractérisé en ce que** l'écran AMOLED est flexible et **en ce que** l'élément de connexion électrique (4) comporte une partie dite terminale (47) qui est contre ou de préférence fixée en face F4,
et **en ce que** le vitrage comprend, sur la face F4, un boitier d'interface (70) connecté à la partie terminale (47) de l'élément de connexion électrique et renfermant un ou des composants électroniques, notamment pour l'écran AMOLED, le boitier d'interface étant en outre connecté avec un système filaire d'alimentation électrique (72) notamment sur un même bord ou sur un bord distinct du boitier d'interface.

2. Vitrage feuilleté de véhicule selon l'une des revendications précédentes **caractérisé en ce que** l'élément de connexion électrique (4) est flexible comporte une partie flexible dite de connectique (40) entre la face F2 et la face F3 avec une surface avant 42 côté face F3 et une surface arrière 41 côté face F2, de préférence au sein de l'intercalaire de feuilletage, d'épaisseur E4 inférieure à E2, reliée à l'écran AMOLED et prolongeant l'écran AMOLED en direction du chant du deuxième vitrage, l'élément de connexion électrique se prolongeant hors du chant du deuxième vitrage par une partie dite extérieure (45) qui est courbée et ladite partie dite terminale.

3. Vitrage feuilleté de véhicule selon l'une des revendications précédentes **caractérisé en ce que** le boitier d'interface est en outre connecté à un système filaire de transport de signaux de données pour l'écran AMOLED, système filaire sur un même bord du boitier d'interface ou sur un bord distinct que pour le système filaire d'alimentation électrique.

4. Vitrage feuilleté de véhicule selon l'une des revendications précédentes **caractérisé en ce que** le boitier d'interface (70) contient un récepteur de données issues d'un réseau local de communication sans fil tel qu'un réseau WLAN, WIFI, BLUETOOTH, transportant des données pour l'écran AMOLED, notamment pour sa commande.

5. Vitrage feuilleté de véhicule selon l'une des revendications précédentes **caractérisé en ce que** le boitier d'interface est monté sur la partie terminale (47) ou est adjacent à la partie terminale (47) et connecté à une extrémité de la partie terminale et contre ou fixé à ladite face F4.

6. Vitrage feuilleté de véhicule selon l'une des revendications précédentes **caractérisé en ce que** le boitier d'interface (47) est en en matière plastique notamment avec des moyens de blindage électromagnétique additionnel et/ou métallique avec une fenêtre de communication pour réception de signaux.

7. Vitrage feuilleté de véhicule selon l'une des revendications précédentes **caractérisé en ce que** la partie de connectique est d'épaisseur submicronique E4 de préférence sensiblement égale à E2 et la partie terminale est d'épaisseur E'4 inférieure à E4.

8. Vitrage feuilleté de véhicule selon l'une des revendications précédentes **caractérisé en ce que** l'écran AMOLED est transparent et dans le clair de vitre ou **en ce que** l'écran AMOLED est masqué par une couche de masquage dite externe (5) entre la face arrière de l'écran AMOLED et la face F2, et/ou l'élément de connexion électrique est masqué de l'extérieur par une couche de masquage dite externe (5) entre la surface arrière et la face F2.

9. Vitrage feuilleté de véhicule selon l'une des revendications précédentes **caractérisé en ce que** le deuxième vitrage porte en face F3 ou F4 une couche de masquage dite interne (6) apte à masquer de l'intérieur :
- le ou les bords techniques de l'écran AMOLED et d'éventuel(s) autre(s) écran(s) AMOLED adjacent(s) ou sur des bords longitudinaux distincts et à masquer même une zone de jonction entre l'intercalaire de feuilletage et l'écran AMOLED ou d'éventuel(s) autre(s) écran AMOLED
- et/ou le ou les éléments de connexion électriques de l'écran AMOLED et d'éventuel(s) autre(s) écran(s) AMOLED adjacent(s) ou sur des bords longitudinaux distincts.

10. Vitrage feuilleté de véhicule selon l'une des revendications précédentes **caractérisé en ce que** le ou les bords techniques de l'écran AMOLED et d'éventuel(s) autre(s) écran(s) AMOLED sont masqués par un élément de masquage dit intérieur sur l'écran AMOLED notamment sous une couche diélectrique de protection ou étant une zone opaque d'une couche de protection diélectrique, notamment une résine,
- et/ou le ou les éléments de connexion électriques sont masqués par ledit élément de masquage intérieur ou un autre adjacent notamment sous une couche diélectrique de protection ou étant une zone opaque d'une couche de protection diélectrique, notamment une résine.

11. Vitrage feuilleté de véhicule selon l'une des revendications précédentes **caractérisé en ce que** l'écran AMOLED (3) et/ou la partie de connectique a une épaisseur au plus égale à 0,8mm, de préférence au plus égale à 0,7mm, et de manière particulièrement préférée au plus égale à 0,6mm.

12. Vitrage feuilleté de véhicule selon l'une des revendications précédentes **caractérisé en ce qu'**il forme un pare-brise de véhicule routier tel qu'une automobile, un camion, avec les premier et deuxième vitrage bombés et même un intercalaire de feuilletage en PVB.

## Patentansprüche

1. Fahrzeug-Verbundverglasung (100 bis 800), vorzugsweise Windschutzscheibe eines Straßenfahrzeugs, die Folgendes umfasst:
- eine erste Verglasung (1) mit einer ersten Hauptfläche (11), F1 genannt, die insbesondere dazu bestimmt ist, sich an der Außenseite des Fahrzeugs zu befinden, und einer zweiten gegenüberliegenden Hauptfläche (12), F2 genannt, vorzugsweise mit einer Stärke E1 von höchstens 2,5 mm
- eine Schichtungseinlage aus Polymermaterial (2) auf der Seite der Fläche F2 mit einer Stärke E2 von vorzugsweise höchstens 2,2 mm
- eine zweite Verglasung (1') mit einer dritten Hauptfläche (13), F3 genannt, auf der Seite der Schichtungseinlage (2) und eine vierte gegenüberliegende Hauptfläche (14), F4 genannt, die insbesondere dazu bestimmt ist, an der Innenseite des Fahrzeugs zu liegen, vorzugsweise mit einer Stärke E'1 von höchstens 2,2 mm, wobei mindestens eine der ersten und der zweiten Verglasung aus Mineralglas besteht,
- zwischen der Fläche F2 und der Fläche F3 einen Visualisierungsbildschirm mit organischer Leuchtdiode, der eine Einheit von Pixeln, AMOLED-Bildschirm (3) genannt, aufweist, wobei der AMOLED-Bildschirm eine Zone (32') zur dynamischen Anzeige von Informationen umfasst, mit einer Stärke E3 kleiner als E2 und die vorzugsweise subzentimetrisch ist, wobei der AMOLED-Bildschirm eine vordere Hauptfläche (32) aufweist, die zu der Fläche F3 gerichtet ist, und eine hintere Fläche (31), die zu der Fläche F2 gerichtet ist, wobei der AMOLED-Bildschirm durch eine Stärke ungleich null einer Schichtungseinlage bedeckt ist und vorzugsweise innerhalb der Schichtungseinlage, wobei der AMOLED-Bildschirm insbesondere an der Peripherie eingerichtet ist,
- ein elektrisches Verbindungselement (4) des AMOLED-Bildschirms, vorzugsweise mit einem flexiblen Anschlussteil (40) zwischen der Fläche F2 und der Fläche F3 mit einer vorderen Oberfläche (42) auf der Seite der Fläche F3 und einer hinteren Oberfläche (41) auf der Seite der Fläche F2, wobei der flexible Anschlussteil durch eine Stärke ungleich null einer Schichtungseinlage bedeckt ist und vorzugsweise innerhalb der Schichtungseinlage, eine Stärke E4 kleiner als E2 und vorzugsweise subzentimetrisch, die mit dem AMOLED-Schirm verbunden ist und den AMOLED-Bildschirm in Richtung der Kante der zweiten Verglasung verlängert, wobei sich das flexible elektrische Verbindungselement dann außerhalb der Kante der zweiten Verglasung über einen Außenteil (45) verlängert,
**dadurch gekennzeichnet, dass** der AMOLED-Bildschirm flexibel ist und dass das elektrische Verbindungselement (4) einen Endteil (47) umfasst, der gegen oder vorzugsweise an der Fläche F4 befestigt ist,
und dass die Verglasung auf der Fläche F4 ein Schnittstellengehäuse (70) umfasst, das mit dem Endteil (47) des elektrischen Verbindungselements verbunden ist und eine oder mehrere elektronische Komponenten einschließt, insbesondere für den AMOLED-Bildschirm, wobei das Schnittstellengehäuse außerdem mit einem verdrahteten Stromversorgungssystem (72) insbesondere auf demselben Rand oder auf einem Rand, der von dem Schnittstellengehäuse unterschiedlich ist, verbunden ist.

2. Fahrzeug-Verbundverglasung nach einem der vorstehenden Ansprüche, **dadurch gekennzeichnet, dass** das elektrische Verbindungselement (4) flexibel ist, einen flexiblen Anschlussteil (40) zwischen der Fläche F2 und der Fläche F3 umfasst, mit einer vorderen Oberfläche (42) auf der Fläche F3 und einer hinteren Oberfläche (41) auf der Fläche F2, vorzugsweise innerhalb der Schichtungseinlage, mit einer Stärke E4 kleiner als E2, die mit dem AMOLED-Bildschirm verbunden ist und und den AMOLED-Bildschirm in Richtung der Kante der zweiten Verglasung verlängert, wobei sich das elektrische Verbindungselement außerhalb der Kante der zweiten Verglasung über einen Außenteil (45), der gekrümmt ist, und den Endteil verlängert.

3. Fahrzeug-Verbundverglasung nach einem der vorstehenden Ansprüche, **dadurch gekennzeichnet, dass** das Schnittstellengehäuse außerdem mit einem verdrahteten Transportsystem von Datensignalen für den AMOLED-Bildschirm, einem verdrahteten System auf demselben Rand des Schnittstellengehäuses oder auf einem unterschiedlichen Rand als für das verdrahtete Stromversorgungssystem verbunden ist.

4. Fahrzeug-Verbundverglasung nach einem der vorstehenden Ansprüche, **dadurch gekennzeichnet, dass** das Schnittstellengehäuse (70) einen Empfänger von Daten, die aus einem drahtlosen lokalen Kommunikationsnetz, wie einem WLAN-, WIFI-, BLUETOOTH-Netzwerk stammen, das Daten für den AMOLED-Bildschirm, insbesondere für seine Steuerung, transportiert.

5. Fahrzeug-Verbundverglasung nach einem der vorstehenden Ansprüche, **dadurch gekennzeichnet, dass** das Schnittstellengehäuse auf dem Endteil (47) angebracht ist oder zu dem Endteil (47) benachbart ist und an einem Ende des Endteils verbunden ist und gegen die oder an der Fläche F4 befestigt ist.

6. Fahrzeug-Verbundverglasung nach einem der vorstehenden Ansprüche, **dadurch gekennzeichnet, dass** das Schnittstellengehäuse (47) aus Kunststoff besteht, insbesondere mit zusätzlichen elektromagnetischen und/oder metallischen Abschirmmitteln mit einem Kommunikationsfenster für den Empfang von Signalen.

7. Fahrzeug-Verbundverglasung nach einem der vorstehenden Ansprüche, **dadurch gekennzeichnet, dass** der Anschlussteil eine Stärke E4 im Submikronbereich aufweist, die vorzugsweise etwa gleich E2 ist, und der Endteil eine Stärke E'4 kleiner als E4 aufweist.

8. Fahrzeug-Verbundverglasung nach einem der vorstehenden Ansprüche, **dadurch gekennzeichnet, dass** der AMOLED-Bildschirm transparent ist und im Scheibensichtteil liegt, oder dass der AMOLED-Bildschirm durch eine äußere Maskierungsschicht (5) zwischen der hinteren Fläche des AMOLED-Bildschirms und der Fläche F2 maskiert ist, und/oder das elektrische Verbindungselement von außen durch eine äußere Maskierungsschicht (5) zwischen der hinteren Oberfläche und der Fläche F2 maskiert ist.

9. Fahrzeug-Verbundverglasung nach einem der vorstehenden Ansprüche, **dadurch gekennzeichnet, dass** die zweite Verglasung auf der Fläche F3 oder F4 eine innere Maskierungsschicht (6) trägt, die fähig ist, von innen zu maskieren:
- den oder die technischen Rand/Ränder des AMOLED-Bildschirms und eines eventuellen anderen benachbarten/eventueller anderer benachbarter AMOLED-Bildschirms/Bildschirme oder auf anderen Längsrändern und sogar eine Verbindungszone zwischen der Schichtungseinlage und dem AMOLED-Bildschirm oder (einem) eventuellen anderen AMOLED-Bildschirm/en zu maskieren
- und/oder das oder die elektrischen Verbindungselemente des AMOLED-Bildschirms und eines eventuellen anderen benachbarten/eventueller anderer benachbarter AMOLED-Bildschirms/Bildschirme oder auf anderen Längsrändern.

10. Fahrzeug-Verbundverglasung nach einem der vorstehenden Ansprüche, **dadurch gekennzeichnet, dass** der oder die technischen Ränder des AMOLED-Bildschirms und eines eventuellen anderen/anderer AMOLED-Bildschirms/Bildschirme durch ein inneres Maskierungselement auf dem AMOLED-Bildschirm maskiert sind, insbesondere unter einer dielektrischen Schutzschicht oder einer opaken Zone einer dielektrischen Schutzschicht, insbesondere einem Harz,
- und/oder das oder die elektrischen Verbindungselemente durch das innere Maskierungselement oder ein anderes benachbartes maskiert sind, insbesondere unter einer dielektrischen Schutzschicht oder einer opaken Zone einer dielektrischen Schutzschicht, insbesondere einem Harz.

11. Fahrzeug-Verbundverglasung nach einem der vorstehenden Ansprüche, **dadurch gekennzeichnet, dass** der AMOLED-Schirm (3) und/oder der Anschlussteil eine Stärke von höchstens 0,8 mm, vorzugsweise von höchstens 0,7 mm und besonders bevorzugt von höchstens gleich 0,6 mm aufweisen.

12. Fahrzeug-Verbundverglasung nach einem der vorstehenden Ansprüche, **dadurch gekennzeichnet, dass** sie eine Windschutzscheibe eines Straßenfahrzeugs, wie eines Kraftfahrzeugs, eines Lastkraftwagens mit der ersten und zweiten Verglasung gewölbt und sogar einer Schichtungseinlage aus PVB bildet.

## Claims

1. A laminated vehicle glazing (100 to 800) preferably road vehicle windshield, comprising:
- a first glazing (1), with a first main face (11) termed F1, notably intended to be on the outside of the vehicle, and a second opposite main face (12) termed F2, preferably of thickness E1 of at most 2.5mm
- a lamination interlayer of polymeric substance (2), on the face F2 side, of thickness E2 preferably of at most 2.2mm
- a second glazing (1'), with a third main face (13) termed F3 on the lamination interlayer (2) side and a fourth opposite main face (14) termed F4, notably intended to be on the inside of the vehicle, preferably of thickness E'1 of at most 2.2mm, one at least of the first and second glazings being made of mineral glass,
- between the face F2 and the face F3, an organic light-emitting diode-based viewing screen, comprising a set of pixels, termed an AMOLED screen (3), the AMOLED screen comprising a zone of dynamic information display (32'), is of thickness E3 less than E2 and preferably subcentimetric, AMOLED screen having a front main face (32) oriented toward the face F3 and a rear face (31) oriented toward the face F2, the AMOLED screen being covered by a non-zero thickness of lamination interlayer and preferably within the lamination interlayer, the AMOLED screen is notably arranged peripherally,
- an electrical connection element (4) of the AMOLED screen, preferably with a flexible so-called connecting part (40) between the face F2 and the face F3 with a front surface (42) on the face F3 side and a rear surface (41) on the face F2 side, flexible connecting part covered by a non-zero thickness of lamination interlayer and preferably within the lamination interlayer, of thickness E4 less than E2 and preferably subcentimetric, linked to the AMOLED screen and extending the AMOLED screen in the direction of the lip of the second glazing, the, flexible, electrical connection element then extending outside of the lip of the second glazing via a so-called exterior part (45),
**characterized in that** the AMOLED screen is flexible and **in that** the electrical connection element (4) comprises a so-called terminal part (47) which is against or preferably fixed on face F4,
and **in that** the glazing comprises, on the face F4, an interface housing (70) connected to the terminal part (47) of the electrical connection element and enclosing one or more electronic components, notably for the AMOLED screen, the interface housing furthermore being connected with a wired power supply system (72) notably on one and the same edge or on a distinct edge of the interface housing.

2. The laminated vehicle glazing as claimed in one of the preceding claims, **characterized in that** the electrical connection element (4) is flexible comprises a flexible so-called connecting part (40) between the face F2 and the face F3 with a front surface 42 on the face F3 side and a rear surface 41 on the face F2 side, preferably within the lamination interlayer, of thickness E4 less than E2, linked to the AMOLED screen and extending the AMOLED screen in the direction of the lip of the second glazing, the electrical connection element extending outside of the lip of the second glazing by a so-called exterior part (45) which is curved and said so-called terminal part.

3. The laminated vehicle glazing as claimed in one of the preceding claims, **characterized in that** the interface housing is furthermore connected to a wired data signals transport system for the AMOLED screen, wired system on one and the same edge of the interface housing or on a distinct edge as for the wired power supply system.

4. The laminated vehicle glazing as claimed in one of the preceding claims, **characterized in that** the interface housing (70) contains a receiver of data arising from a local wireless communication network such as a WLAN, WIFI, BLUETOOTH network, transporting data for the AMOLED screen, notably for its control.

5. The laminated vehicle glazing as claimed in one of the preceding claims, **characterized in that** the interface housing is mounted on the terminal part (47) or is adjacent to the terminal part (47) and connected to an end of the terminal part and against or fixed to said face F4.

6. The laminated vehicle glazing as claimed in one of the preceding claims, **characterized in that** the interface housing (47) is made of plastic notably with means of extra and/or metallic electromagnetic shielding with a communication window for signals reception.

7. The laminated vehicle glazing as claimed in one of the preceding claims, **characterized in that** the connecting part is of submicronic thickness E4 preferably substantially equal to E2 and the terminal part is of thickness E'4 less than E4.

8. The laminated vehicle glazing as claimed in one of the preceding claims, **characterized in that** the AMOLED screen is transparent and in the clear window region or **in that** the AMOLED screen is masked by a so-called external masking layer (5) between the rear face of the AMOLED screen and the face F2, and/or the electrical connection element is masked from the exterior by a so-called external masking layer (5) between the rear surface and the face F2.

9. The laminated vehicle glazing as claimed in one of the preceding claims, **characterized in that** the second glazing bears on face F3 or F4 a so-called internal masking layer (6) able to mask from the interior:
- the technical edge or edges of the AMOLED screen and optional other AMOLED screen(s) that is or are adjacent or on distinct longitudinal edges and to mask even a junction zone between the lamination interlayer and the AMOLED screen or optional other AMOLED screen(s)
- and/or the electrical connection element or elements of the AMOLED screen and optional other AMOLED screen(s) that is or are adjacent or on distinct longitudinal edges.

10. The laminated vehicle glazing as claimed in one of the preceding claims, **characterized in that** the technical edge or edges of the AMOLED screen and of optional other AMOLED screen(s) are masked by a so-called interior masking element on the AMOLED screen notably under a dielectric protective layer or being an opaque zone of a dielectric protective layer, notably a resin,
- and/or the electrical connection element or elements are masked by said interior masking element or another adjacent one notably under a dielectric protective layer or being an opaque zone of a dielectric protective layer, notably a resin.

11. The laminated vehicle glazing as claimed in one of the preceding claims, **characterized in that** the AMOLED screen (3) and/or the connecting part has a thickness at most equal to 0.8mm, preferably at most equal to 0.7mm, and in a particularly preferred manner at most equal to 0.6mm.

12. The laminated vehicle glazing as claimed in one of the preceding claims, **characterized in that** it forms a windshield of a road vehicle such as an automobile, a truck, with the first and second glazing cambered and even a PVB lamination interlayer.
